(19) **Europäisches Patentamt European Patent Office Office européen des brevets**

(11) **EP 2 920 597 B1**

(12) **FASCICULE DE BREVET EUROPEEN**

(45) Date de publication et mention de la délivrance du brevet:
**20.03.2019 Bulletin 2019/12**

(21) Numéro de dépôt: **13789591.8**

(22) Date de dépôt: **14.11.2013**

(51) Int Cl.:
**G01R 15/06** *(2006.01)*      **G01B 17/00** *(2006.01)*

(86) Numéro de dépôt international:
**PCT/EP2013/073881**

(87) Numéro de publication internationale:
**WO 2014/076210 (22.05.2014 Gazette 2014/21)**

(54) **CAPTEUR DE TENSION DE LIGNE A TRES HAUTE TENSION A COURANT CONTINU**

SPANNUNGSSENSOR FÜR GLEICHSTROMLEITUNG MIT SEHR HOHER SPANNUNG

VERY HIGH VOLTAGE DC LINE VOLTAGE SENSOR

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **16.11.2012 FR 1260922**

(43) Date de publication de la demande:
**23.09.2015 Bulletin 2015/39**

(73) Titulaire: **General Electric Technology GmbH 5400 Baden (CH)**

(72) Inventeurs:
• **CHATREFOU, Denis F-13320 Bouc Bel Air (FR)**
• **MIRONNEAU, Jean-François F-69003 Lyon (FR)**
• **TROUBAT, Vincent F-38300 Bourgoin Jallieu (FR)**

(74) Mandataire: **Fischer, Michael Maria et al General Electric Technology GmbH GE Corporate Intellectual Property Brown Boveri Strasse 7 5400 Baden (CH)**

(56) Documents cités:
**EP-A1- 0 980 003      WO-A1-99/15906 WO-A1-2008/148727**

**Description**

Domaine technique et art antérieur

La présente invention concerne un capteur de tension de ligne à très haute tension à courant continu.

Le domaine d'application de l'invention est celui de la transmission de l'énergie électrique sur les lignes à très haute tension à courant continu. Par « très haute tension à courant continu », il faut entendre, par exemple, des tensions pouvant atteindre 1100kV en courant continu.

La connaissance de la tension sur une ligne à très haute tension ou entre les jeux de barres de sous-stations électriques est nécessaire pour réaliser les fonctions de protection, de contrôle et de comptage de l'énergie. La solution qui existe, à ce jour, pour mesurer cette tension est d'utiliser des diviseurs de tension.

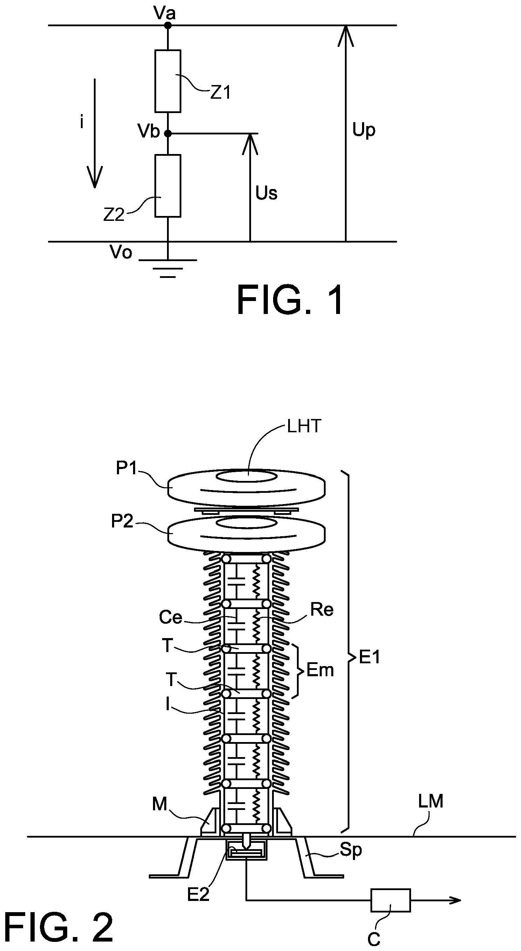

Le schéma de principe d'un diviseur de tension est donné en figure 1.

Le diviseur de tension est constitué de deux impédances Z1 et Z2 montées en série et qui relient la ligne haute tension de potentiel Va à la ligne de masse de potentiel Vo. Un courant i parcourt les impédances Z1 et Z2. Le point milieu entre les impédances Z1 et Z2 est au potentiel Vb. Il vient :

$$(Va - Vb) = Z1 \times i,$$

et

$$(Vb - Vo) = Z2 \times i$$

En conséquence :

$$(Va - Vo) = (Z1 + Z2) \times i,$$

et donc :

$$(Vb - Vo) = (Z2/(Z1+Z2)) \times (Va - Vo)$$

La quantité (Z2/(Z1+Z2)) est par définition le rapport Rp du diviseur de tension. La tension (Vb-Vo) qui est mesurée par le diviseur de tension est l'image de la tension (Va - Vo) qui est présente sur la ligne.

Les capteurs de mesure de très haute tension à courant continu doivent être aptes à mesurer des tensions continues et des tensions alternatives. Les tensions alternatives qui sont mesurées correspondent aux fluctuations de la tension continue. Les fréquences concernées peuvent atteindre, par exemple, 5 kHz. De façon préférentielle, les capteurs de mesure sont calculés pour être indépendants de la fréquence.

Afin de réaliser une division de tension indépendante de la fréquence, le rapport Rp doit être indépendant de la fréquence. Chaque impédance Zi (i=1, 2) est alors constituée d'une résistance Ri (i=1, 2) et d'un condensateur Ci (i=1, 2) montés en parallèle, la condition suivante étant réalisée entre les éléments Ri et Ci :

$$R1 \times C1 = R2 \times C2.$$

Il vient alors:

$$Rp = R2/(R1 + R2),$$

ou encore :

$$Rp = C1/(C1 + C2).$$

Le rapport Rp est alors indépendant de la fréquence. C'est ce type de diviseur de tension, communément appelé diviseur résistif/capacitif ou diviseur RC, qui est préférentiellement utilisé pour les mesures de tension sur les lignes à très haute tension continue.

A ce jour, les diviseurs RC sont réalisés en utilisant des composants capacitifs à base de techniques d'isolation « papier/polypropylène - gaz SF6 », sous une pression élevée du gaz SF6. Ces technologies conduisent souvent à des défauts internes d'isolement et leurs applications sont souvent limitées à des tensions inférieures à 800 kV. Par ailleurs, la stabilité en température des mesures en DC (i.e. en courant continu) et en AC (i.e. en courant alternatif) ainsi que la précision des mesures des harmoniques en AC pour les fréquences allant jusqu'à 5kHz, sont actuellement insuffisantes par rapport aux demandes spécifiées dans la plupart des cahiers des charges.

L'invention ne présente pas les inconvénients mentionnés ci-dessus.

Il est connu de l'art antérieur la demande internationale WO 2008/148 727 A1 (ABB TECHNOLOGY AG [CH] ; BJOERKLUND HANS [SE] ; NYBERG KRYSTER [SE] ; 11 décembre 2008). Ce document divulgue un dispositif de mesure de tension qui comprend une succession d'éléments de division de tension entre une ligne haute tension et la masse électrique.

La demande de brevet EP 0 980 003 A1 (TRENCH SWITZERLAND AG [CH] ; 16 février 2000) et la demande internationale WO 99/15906 A1 (HAEFELY TRENCH AG [CH] ; MINKNER RUTHARD [CH] ; SCHMID JOACHIM [DE] ; 1 avril 1999) sont également connus de l'art antérieur.

Exposé de l'invention

En effet, l'invention concerne un capteur de tension de ligne à très haute tension à courant continu, le capteur étant constitué d'un diviseur de tension comprenant deux étages de division de tension connectés en série, une tension intermédiaire étant prélevée au point de connexion des deux étages de division de tension, un premier étage de division de tension étant constitué d'au moins deux étages élémentaires de division de tension montés en série et répartis dans un isolateur composite, chaque étage élémentaire de division de tension comprenant au moins un condensateur et au moins une résistance en parallèle, caractérisé en ce que le condensateur et la résistance ayant chacun une première borne fixée sur une première plaque électriquement conductrice et une deuxième borne, opposée à la première borne, fixée sur une deuxième plaque électriquement conductrice, la première plaque électriquement conductrice et la deuxième plaque électriquement conductrice étant entourées, chacune, par un capot électriquement conducteur, au moins une pièce électriquement isolante de maintien qui enserre la résistance et le condensateur étant en contact avec la paroi interne de l'isolateur composite afin de fixer le condensateur et la résistance à l'intérieur de l'isolateur composite.

Selon une caractéristique supplémentaire de l'invention, la première plaque électriquement conductrice est une plaque rigide d'une première pièce mécanique de maintien électriquement conductrice et la deuxième plaque électriquement conductrice est constituée d'une feuille métallique souple en forme d'araignée solidaire d'une couronne en acier d'une deuxième pièce mécanique de maintien électriquement conductrice, une première plaque électriquement conductrice et une deuxième plaque électriquement conductrice d'une même pièce mécanique de maintien électriquement conductrice étant reliées l'une à l'autre par des entretoises électriquement conductrices.

Selon une autre caractéristique supplémentaire de l'invention, le deuxième étage de division de tension est constitué de composants électroniques comprenant des condensateurs et/ou des résistances interchangeables.

Selon encore une autre caractéristique supplémentaire de l'invention, le deuxième étage de division de tension comprend au moins un condensateur et au moins une résistance en parallèle contenus dans un boîtier étanche, un câble blindé reliant électriquement le deuxième étage de division de tension au premier étage de division de tension.

Selon encore une autre caractéristique supplémentaire de l'invention, un circuit électronique a une entrée reliée à une sortie du deuxième étage de division de tension et le circuit électronique comprend des circuits de traitement du signal qu'il reçoit sur son entrée.

Selon encore une autre caractéristique supplémentaire de l'invention, les circuits de traitement comprennent un convertisseur analogique/numérique.

Selon encore une autre caractéristique supplémentaire de l'invention, le premier étage de division de tension est équipé de moyens de mesure de température aptes à délivrer une température du capteur.

Selon encore une autre caractéristique supplémentaire de l'invention, le circuit électronique comprend des moyens aptes à corriger des dérives en température des valeurs de résistance et/ou des valeurs de capacité de condensateur du premier et/ou du deuxième étage de division de tension, sur la base de mesures de température délivrées par les moyens de mesure de température.

Selon encore une autre caractéristique supplémentaire de l'invention, la très haute tension est comprise entre 100kV en continu et 1100kV en continu et la tension intermédiaire est comprise entre 100V et 200V en continu.

Selon encore une autre caractéristique supplémentaire de l'invention, l'isolateur composite est un tube en fibre de verre époxy recouvert d'ailettes en silicone.

Un avantage du capteur de tension de l'invention est de permettre que soient absorbées les variations de dimension des condensateurs et des résistances qui sont liées aux dispersions de fabrication et/ou aux dilatations différentielles desdits condensateurs et résistances.

Brève description des figures

D'autres caractéristiques et avantages de l'invention apparaîtront à la lecture d'un mode de réalisation préférentiel de l'invention fait en référence aux figures jointes, parmi lesquelles :

- La figure 1, déjà décrite, représente le schéma de principe d'un diviseur de tension ;
- La figure 2 représente un schéma de capteur de tension selon le mode de réalisation préférentiel de l'invention ;
- La figure 3 représente une vue de détail du capteur de tension représenté en figure 2 ;
- La figure 4 représente une vue de détail de l'isolateur composite qui participe à la réalisation du capteur de tension selon le mode de réalisation préférentiel de l'invention.

Sur toutes les figures, les mêmes références désignent les mêmes éléments.

Exposé détaillé d'un mode de réalisation préférentiel de l'invention

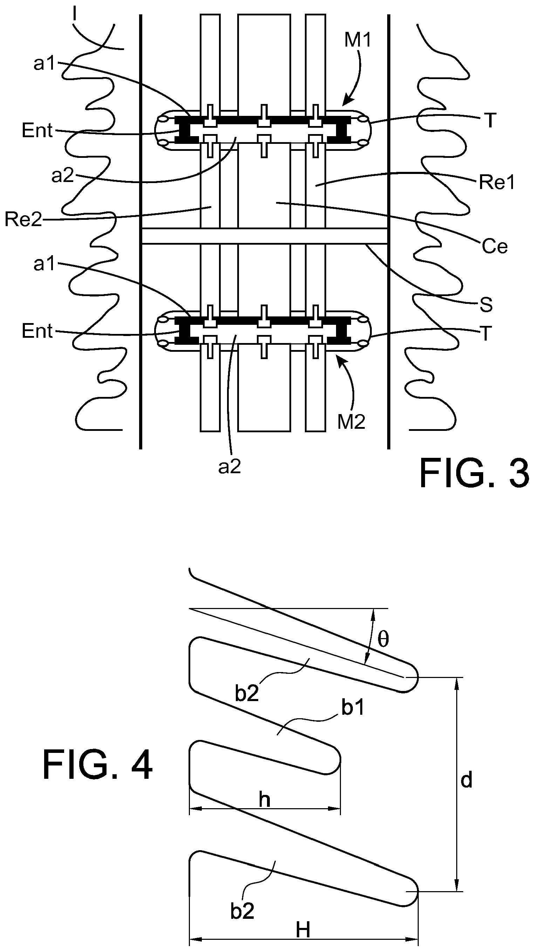

La figure 2 représente un schéma de capteur de tension selon le mode de réalisation préférentiel de l'invention et la figure 3 représente une vue de détail du capteur de tension représenté en figure 2.

Le capteur de tension comprend deux étages de division de tension E1, E2 montés en série. Une première borne du premier étage de division E1 prélève la tension sur une ligne à très haute tension LHT et la deuxième borne du premier étage E1 est électriquement reliée à la première borne du deuxième étage E2 dont la deuxième borne est reliée à la ligne de masse LM.

Une ou deux pièces électriquement conductrices P1, P2 sont placées au niveau où la première borne du premier étage E1 prélève la tension sur la ligne LHT de façon à protéger, d'un point de vue électrique, la connexion entre la ligne et le diviseur de tension (suppression des effets de pointe).

Le premier étage de division E1 comprend une pluralité d'étages de division élémentaires Em montés en série, chaque étage de division élémentaire comprenant un condensateur Ce et une résistance Re montés en parallèle et maintenus à l'intérieur d'un isolateur composite I. Le condensateur Ce et la résistance Re sont des composants discrets de technologie standard aptes à supporter les valeurs de tension assignées au bon fonctionnement du capteur (valeurs typiquement comprises entre 100kV et 1100kV en continu divisés par le nombre N d'étages du diviseur). A titre d'exemple non limitatif, les dimensions géométriques d'un condensateur Ce sont de l'ordre de la trentaine de centimètres et la tension maximale assignée à ce condensateur de l'ordre de 50kV en courant continu. Il en est de même pour une résistance Re dont la longueur est environ de trente centimètres et supporte une tenue électrique de 50kV en courant continu. De façon préférentielle, comme cela est représenté sur la figure 3, une résistance Re est réalisée par la mise en parallèle de deux résistances Re1 et Re2.

Dans le mode de réalisation préférentiel de l'invention représenté en figure 3, les résistances et les condensateurs de deux étages élémentaires voisins sont fixés à même une pièce mécanique de maintien électriquement conductrice Mi(i=1, 2, ...), qui comprend une plaque électriquement conductrice épaisse et rigide a1 et une feuille métallique souple, par exemple en acier, en forme d'araignée solidaire d'une couronne épaisse en acier a2.

Les condensateurs et les résistances d'un même étage élémentaire Em sont fixés entre deux pièces mécaniques de maintien électriquement conductrices. Chaque résistance et chaque condensateur d'un étage de division élémentaire Em a ainsi une première borne fixée, par exemple par vissage, à la plaque a1 d'une première pièce mécanique de maintien M1 et une deuxième borne fixée, par exemple par vissage, dans la feuille métallique souple en forme d'araignée solidaire d'une couronne épaisse en acier a2 d'une deuxième pièce mécanique de maintien M2.

Un tel montage permet avantageusement que des variations de dimension des condensateurs et des résistances liées à leurs dispersions de fabrication et/ou aux dilatations différentielles soient absorbées. La cohésion entre la plaque a1 et la plaque a2 d'une même pièce mécanique électriquement conductrice de maintien est assurée par des entretoises électriquement conductrices Ent.

Un capot électriquement conducteur T entoure les plaques a1, a2 d'une même pièce mécanique de maintien. Ce capot a pour fonction de répartir correctement les lignes de champ électrique entre les différents étages de division élémentaires. Sa forme est avantageusement calculée pour tenir les tensions de claquage. A titre d'exemple non limitatif, selon le mode de réalisation préférentiel de l'invention, chaque capot électriquement conducteur T est équipé d'un élément métallique plat soudé sur la face interne du capot et qui présente une série de trous filetés dans lesquels des vis fixent le capot aux éléments conducteurs a1 et a2.

Pour chaque étage de division élémentaire Em, une pièce électriquement isolante de maintien S (cf. figure 3) enserre le condensateur Ce et les résistances Re1 et Re2 et prend appui sur la paroi interne de l'isolateur composite I. La pièce de maintien S permet de centrer les condensateurs et les résistances dans l'isolateur composite avec un jeu suffisant pour réaliser un montage facile. L'isolateur composite I contient de l'air sec sous une atmosphère dont la pression est préférentiellement supérieure de $3\times10^4$ Pa à la pression atmosphérique, ce qui évite avantageusement que le capteur ne soit placé en dépression lorsque les températures deviennent négatives.

Avantageusement, l'édifice mécanique que constitue le premier étage E1 est un système « flottant » qui assure le maintien mécanique des condensateurs et des résistances sans contraintes (dilatations thermiques ; flexion de l'isolateur composite). Par ailleurs, la continuité électrique qui existe entre le haut et le bas du premier étage E1 assure une excellente tenue diélectrique lorsque le capteur est soumis aux tensions assignées (présence des capots arrondis dont la forme est calculée pour tenir les tensions diélectriques).

Un câble blindé relie le premier étage et le deuxième étage. Le deuxième étage E2 comprend des résistances et des condensateurs dont le schéma équivalent est constitué d'un condensateur C2 en parallèle avec une résistance R2. De façon avantageuse, il est possible de changer la capacité de un ou plusieurs condensateurs du deuxième étage E2 afin de régler la tension intermédiaire délivrée par le deuxième étage.

La sortie du deuxième étage de division de tension est reliée à l'entrée d'un circuit de traitement C. Le circuit de traitement C comprend un convertisseur analogique/numérique qui convertit la tension analogique intermédiaire délivrée par le deuxième étage en un signal numérique.

Selon un perfectionnement de l'invention, des moyens de mesure de température aptes à délivrer une température du capteur sont placés dans le premier étage E1 et la mesure de température délivrée par ces moyens de mesure est transmise au circuit de traitement C. Le circuit de traitement C comprend alors des moyens aptes à corriger les dérives en température des valeurs de résistance et/ou de capacité de condensateur du premier et/ou du deuxième étage de division de tension, sur la base des mesures de température délivrées par les moyens de mesure de température.

La figure 4 représente une vue de détail de l'isolateur composite qui participe à la réalisation du capteur de tension selon le mode de réalisation préférentiel de l'invention.

L'isolateur composite est de type monolithique, c'est-à-dire fabriqué d'un seul tenant en utilisant un tube en fibre de verre époxy recouvert d'ailettes en silicone. Les ailettes en silicone présentent un profil capable d'atteindre la ligne de fuite qui est spécifiée dans le cahier des charges du capteur de tension. Pour un capteur de tension apte à mesurer une tension égale à 800kV en continu, la ligne de fuite spécifiée est de 54,5mm/kV. La figure 4 illustre un profil d'ailettes de l'isolateur contenant le capteur de tension apte à mesurer une tension de 800kV en continu. Du haut en bas de l'isolateur les ailettes, orientées vers le sol, se succèdent de sorte qu'une ailette de petite dimension b1 succède à une ailette de grande dimension b2. Par ailette de petite dimension, il faut entendre, par exemple, une ailette dont la distance h qui sépare son extrémité du corps de l'isolateur est égale à 50mm. De même, par ailette de grande dimension, il faut entendre, par exemple, une ailette dont la distance H qui sépare son extrémité du corps de l'isolateur est égale à 70mm. La distance d qui sépare deux ailettes de même dimension est égale, par exemple, à 60mm. L'angle $\theta$ que fait chaque ailette (petite ou grande) avec l'horizontale est sensiblement égal à 30°.

A titre d'exemple non limitatif, le choix des composants constitutifs d'un capteur de tension selon l'invention va maintenant être décrit. Le capteur de tension a, par exemple, les caractéristiques suivantes :

- tension d'usage de 800kV en continu ;
- tension maximale continue devant être tenue durant une heure : 1230kV ;
- tension de tenue aux chocs de foudre : 2250kV (onde de tension dont le temps de montée est de 1,2$\mu$s et le temps de descente de 50$\mu$s) ;
- tension de tenue aux fréquences industrielles (50Hz) : 1070kV en courant alternatif (avec mesure de décharges partielles et limite maximale à 10pC) ;
- précision des mesures en continu: classe 0,1% à 0,2% ;
- précision des mesures en alternatif : classe 1% à 3% jusqu'à 5kHz ;
- courant parcourant le capteur compris entre 1mA et 2mA.

Pour la conception d'un tel capteur, chaque étage élémentaire Em est choisi pour tenir une tension continue maximale de 52kV avec un espace inter-étage d'environ 40cm. Il s'en suit que le nombre N d'étages élémentaires du premier étage de division de tension est égal à 24 (1230/52) et que la hauteur du premier étage est sensiblement égale à 9,6m.

Comme cela est apparu en référence à la figure 1, un rapport de division Rp indépendant de la fréquence s'écrit :

(a) Rp = R2 / (R1+R2), ou encore
(b) Rp = C1 / (C1+C2)

Lorsque la tension est purement continue, seules les résistances interviennent dans le calcul du rapport (équation (a)) et lorsque la tension est alternative de fréquence élevée, seules les capacités interviennent (équation (b)).

La technologie de fabrication des résistances haute tension utilise des barreaux de céramique sur lesquels sont déposées des pistes conductrices très fines qui utilisent un alliage (par exemple, un mélange d'Oxyde de Ruthénium RuO2 et de silice) dont la résistivité est très stable en température. Il est donc relativement facile de réaliser des résistances ayant une grande stabilité thermique, typiquement comprise, par exemple, entre 10 et 20ppm/°C. Compte tenu de la disparité des coefficients de dérive des résistances, il est toutefois nécessaire de corriger la mesure pour des dynamiques de température importantes (mesures de température associées à des tables de correction en fonction de la température).

Par ailleurs, la technologie de fabrication des condensateurs standards utilise des films isolants de polypropylène sur lesquels sont déposées des argentures qui forment les plaques conductrices des électrodes du condensateur. Un double enroulement imbriqué de ce type de film réalise alors le condensateur. Cette technologie ne permet pas d'obtenir une capacité ayant une grande stabilité thermique. Les mesures de température sont également ici aussi nécessaires pour corriger les mesures.

Choix des valeurs des résistances R1 et Re

La mesure de la tension continue doit être extrêmement précise (classe 0,1% à 0,2%). Pour cette mesure, seul le diviseur résistif intervient. Le choix de la valeur de la résistance R1 du premier étage E1 est imposé par deux contraintes contradictoires, à savoir :

- que la résistance R1 ait une valeur suffisamment basse pour ne pas être perturbée par des résistances parasites; et
- que la résistance R1 ait une valeur suffisamment élevée pour éviter que trop de courant ne soit dérivé dans le capteur.

Par ailleurs, comme cela a été mentionné ci-dessus, le cahier des charges limite le courant à une valeur comprise entre 1 et 2mA.

A titre d'exemple non limitatif, pour une valeur de courant égale à 1,33mA, la résistance R1 est égale à 600MΩ (en effet : R1=800kV/1,33mA). Le premier étage étant formé de 24 étages élémentaires, il s'en suit que la résistance Re d'un étage élémentaire est égale à 25MΩ (600MΩ = 24 x 25 MΩ). De façon préférentielle, la résistance Re est alors réalisée à l'aide de deux résistances de 50MΩ en parallèle. Cela permet d'homogénéiser la température dégagée par le passage du courant dans les résistances et de servir de redondance. En effet, en cas de défaut, par exemple la coupure d'une piste d'une résistance, le diviseur peut continuer de fonctionner grâce à l'autre résistance qui pourra supporter le double de courant ; sa puissance est prévue pour cette alternative de fonctionnement. La précision sera légèrement dégradée (différence du rapport de résistances égale à 625/600) mais suffisante pour continuer d'alimenter des systèmes de protection et de contrôle garantissant la sécurité de l'ouvrage électrique.

Choix des valeurs de capacité des condensateurs C1 et Ce

Le choix de la valeur de la capacité du condensateur Ce est également imposée par deux contraintes contradictoires, à savoir :

- avoir une valeur suffisamment basse pour ne pas influencer la précision du diviseur de tension aux basses fréquences ; et
- avoir une valeur suffisamment élevée pour éviter d'être perturbée par la présence de capacités parasites qui peuvent apparaître entre les parties médianes du diviseur de tension et la terre ou de la ligne à haute tension.

Un calcul de valeur de capacité lié au seul premier critère est effectué ci-dessous.

Il existe une fréquence du signal pour laquelle l'impédance liée à la résistance R1 est égale à l'impédance liée au condensateur C1. C'est le cas où autant de courant passe dans le condensateur C1 et dans la résistance R1. Dans la suite de la description, cette fréquence du signal est appelé « fréquence de basculement ». Il est souhaitable que la fréquence de basculement soit assez éloignée du continu afin que la résistance R1 l'emporte sur le condensateur C1 pour l'écoulement du courant.

A la fréquence de basculement, comme indiqué ci-dessus, la relation suivante est vérifiée :

$$R1 = 1 / (C1 \times \omega)$$

avec $\omega = 2\pi f_{basc}$

La fréquence de basculement $f_{basc}$ s'écrit en conséquence :

$$f_{basc} = 1 / (2\pi \times R1 \times C1),$$

et la capacité C1 :

$$C1 = 1/(2\pi \times R1 \times f_{basc})$$

Si l'on choisit comme valeur de fréquence de basculement 1Hz, il vient, pour la résistance R1 de 600MΩ mentionnée ci-dessus :

$$C1 = 300 \ pF$$

Une telle valeur de capacité est un peu trop faible pour être insensible aux capacités parasites. La valeur choisie dans le cadre du mode de réalisation préférentiel de l'invention est alors légèrement supérieure à la valeur calculée ci-dessus, par exemple 500pF. Il a été constaté que cette valeur de capacité du condensateur remplit correctement les critères souhaités.
Il est alors possible d'en déduire la valeur de la capacité d'un condensateur d'étage élémentaire :

$$Ce = 24 \times 500 \ pF,$$

soit :

$$Ce = 12nF$$

Choix des valeurs de la résistance R2 et de la capacité du condensateur C2.

Ce sont les valeurs de la capacité C2 et de la résistance R2 qui fixent la tension intermédiaire de sortie. Comme cela a été mentionné précédemment, la valeur choisie de la tension de sortie pour le mode de réalisation préférentiel de l'invention est égale à 200V. Une telle valeur de tension permet de choisir une valeur de capacité du condensateur C2 suffisamment importante pour que la capacité du câble de connexion entre le premier et le deuxième étage soit négligeable (la capacité linéique du câble de connexion est, par exemple, comprise entre 10pF/m et 100pF/m).
Pour calculer les valeurs de R2 et de C2, la tension de sortie du diviseur de tension est imposée, par exemple égale à 200V. Dans ce cas, le rapport du diviseur de tension Rp est imposé et sa valeur est :

$$Rp = 200V / 800000V$$

soit :

$$Rp = 1/4000$$

Compte tenu, par ailleurs, des équations reliant les composants du diviseur de tension au rapport de division Rp, il vient :

$$Rp = R2 / (R1 + R2),$$

et aussi

$$Rp = C1 / (C1 + C2)$$

On en déduit alors que :

$$R2 = R1 / (4000-1)$$

$$C2 = (4000-1) \times C1$$

D'où :

$$R2 \approx 150k\Omega \quad et \quad C2 \approx 2000nF$$

Un avantage essentiel du capteur de tension de l'invention est de permettre un ajustement très précis du rapport de tension. La valeur du condensateur C2 est modifiée en ajoutant ou en retranchant des condensateurs montés en parallèle, à cette fin, sur le circuit C. Le choix de ces condensateurs résulte, par exemple, de simulations mathématiques. La tension intermédiaire est alors ajustée, par un diviseur résistif large bande, à une valeur (par exemple +/-10V) compatible avec les convertisseurs analogique/numérique. Le circuit électronique C comprend, à cette fin, un convertisseur analogique-numérique qui convertit la tension intermédiaire en un signal numérique qui est transmis par un système de transmission numérique sur fibre optique.

La numérisation du signal s'effectue ainsi avantageusement dans le circuit C qui est situé au pied du capteur et les données de mesure peuvent alors être avantageusement transportées sur une longue distance, à partir du circuit C, par transmission numérique sur la fibre optique.

La numérisation du signal conserve toutes les caractéristiques de bande passante du signal. A titre d'exemple non limitatif, le signal est échantillonné à 200kHz après avoir été filtré par un filtre analogique passe-bas anti repliement (« anti-aliasing » en langue anglaise) qui garantit la précision et la stabilité en fréquence. Le signal est ensuite décimé à 42kHz puis transporté par voie optique numérique, par exemple à 100Mbit/s.

En plus des avantages précédemment cités, d'autres avantages du capteur de tension de l'invention peuvent être cités, à savoir :

- une sécurité accrue du capteur du fait d'une probabilité d'explosion très faible ;
- un respect des conditions environnementales (pas d'huile, pas de gaz SF6, mais une isolation sous air sec à la pression atmosphérique) ;
- une simplification du câblage de l'étage secondaire ;
- une maintenance facilitée par un logiciel d'interface homme- machine intelligent ;
- la possibilité de supporter une panne sur un canal de mesure sans interruption du service, grâce aux redondances électroniques, évitant ainsi les interruptions intempestives de la sous-station qui sont généralement très coûteuses.

**Revendications**

1. Capteur de tension de ligne à très haute tension à courant continu, le capteur étant constitué d'un diviseur de tension comprenant deux étages de division de tension connectés en série, une tension intermédiaire étant prélevée au point de connexion des deux étages de division de tension, un premier étage de division de tension (E1) étant constitué d'au moins deux étages élémentaires de division de tension (Em) montés en série et répartis dans un isolateur composite (I), chaque étage élémentaire de division de tension (Em) comprenant au moins un condensateur (Ce) et au moins une résistance (Re) en parallèle, **caractérisé en ce que** le condensateur et la résistance ont chacun une première borne fixée sur une première plaque électriquement conductrice (a1) et une deuxième borne, opposée à la première borne, fixée sur une deuxième plaque électriquement conductrice (a2), la première plaque électriquement conductrice (al) et la deuxième plaque électriquement conductrice (a2) étant entourées, chacune, par un capot électriquement conducteur (T), au moins une pièce électriquement isolante de maintien (S) qui enserre la résistance et le condensateur étant en contact avec la paroi interne de l'isolateur composite (I) afin de fixer le condensateur et la résistance à l'intérieur de l'isolateur composite.

2. Capteur de tension de ligne à très haute tension à courant continu selon la revendication 1, dans lequel la première plaque électriquement conductrice (a1) est une plaque rigide d'une première pièce mécanique de maintien électriquement conductrice et la deuxième plaque électriquement conductrice (a2) est constituée d'une feuille métallique souple en forme d'araignée solidaire d'une couronne en acier d'une deuxième pièce mécanique de maintien électriquement conductrice, une première plaque électriquement conductrice (a1) et une deuxième plaque électriquement conductrice (a2) d'une même pièce mécanique de maintien électriquement conductrice étant reliées l'une à l'autre par des entretoises (Ent) électriquement conductrices.

3. Capteur de tension selon l'une des revendications 1 ou 2, dans lequel le deuxième étage de division de tension (E2) est constitué de composants électroniques comprenant des condensateurs et/ou des résistances interchangeables.

4. Capteur de tension de ligne à très haute tension à courant continu selon la revendications 3, dans lequel le deuxième étage de division de tension (E2) comprend au moins un condensateur et au moins une résistance en parallèle contenus dans un boîtier étanche, un câble blindé reliant électriquement le deuxième étage de division de tension au premier étage de division de tension.

5. Capteur de tension de ligne à très haute tension à courant continu selon l'une quelconque des revendications précédentes, dans lequel un circuit électronique (C) a une entrée reliée à une sortie du deuxième étage de division de tension et le circuit électronique (C) comprend des circuits de traitement du signal qu'il reçoit sur son entrée.

6. Capteur de tension de ligne à très haute tension à courant continu selon la revendication 5, dans lequel les circuits de traitement comprennent un convertisseur analogique/numérique.

7. Capteur de tension de ligne à très haute tension à courant continu selon l'une quelconque des revendications précédentes, dans lequel le premier étage de division de tension est équipé de moyens de mesure de température aptes à délivrer une température du capteur.

8. Capteur de tension de ligne à très haute tension à courant continu selon la revendication 7, lorsque la revendication 7 dépend de la revendication 5 ou 6, dans lequel le circuit électronique (C) comprend des moyens aptes à corriger des dérives en température des valeurs de résistance et/ou des valeurs de capacité de condensateur du premier et/ou du deuxième étage de division de tension, sur la base de mesures de température délivrées par les moyens de mesure de température.

9. Capteur de tension de ligne à très haute tension à courant continu selon l'une quelconque des revendications précédentes, dans lequel la très haute tension est comprise entre 100kV en continu et 1100kV en continu et la tension intermédiaire est comprise entre 100V et 200V en continu.

10. Capteur de tension de ligne à très haute tension à courant continu selon l'une quelconque des revendications précédentes, dans lequel l'isolateur composite (I) est un tube en fibre de verre époxy recouvert d'ailettes en silicone (b1, b2).

**Patentansprüche**

1. Spannungssensor für eine Gleichstromleitung mit sehr hoher Spannung, wobei der Sensor aus einem Spannungsteiler besteht, der zwei in Reihe verbundene Spannungsteilungsstufen umfasst, wobei eine Zwischenspannung am Verbindungspunkt der zwei Spannungsteilungsstufen abgegriffen wird, wobei eine erste Spannungsteilungsstufe (E1) aus mindestens zwei elementaren Spannungsteilungsstufen (Em) besteht, die in Reihe montiert und in einem Verbundisolator (I) verteilt sind, wobei jede elementare Spannungsteilungsstufe (Em) mindestens einen Kondensator (Ce) und mindestens einen Widerstand (Re) in Parallelschaltung umfasst, **dadurch gekennzeichnet, dass** der Kondensator und der Widerstand jeder einen ersten Anschluss aufweisen, der an einer ersten elektrisch leitenden Platte (a1) befestigt ist, und einen dem ersten Anschluss gegenüberliegenden zweiten Anschluss, der an einer zweiten elektrisch leitenden Platte (a2) befestigt ist, wobei die erste elektrisch leitende Platte (a1) und die zweite elektrisch leitende Platte (a2) jede von einer elektrisch leitenden Abdeckung (T) umgeben sind, wobei sich mindestens ein elektrisch isolierendes Halteteil (S), das den Widerstand und den Kondensator einspannt, mit der Innenwand des Verbundisolators (I) in Kontakt befindet, um den Kondensator und den Widerstand im Inneren des Verbundisolators zu befestigen.

2. Spannungssensor für eine Gleichstromleitung mit sehr hoher Spannung nach Anspruch 1, wobei die erste elektrisch leitenden Platte (a1) eine starre Platte eines ersten elektrisch leitenden mechanischen Halteteils ist, und die zweite elektrisch leitende Platte (a2) aus einer nachgiebigen Metallfolie in Spinnenform besteht, die fest mit einem Stahlkranz eines zweiten elektrisch leitenden mechanischen Halteteils verbunden ist, wobei eine erste elektrisch leitende Platte (a1) und eine zweite elektrisch leitende Platte (a2) ein und desselben elektrisch leitenden mechanischen Halteteils über elektrisch leitende Stege (Ent) miteinander verbunden sind.

3. Spannungssensor nach einem der Ansprüche 1 oder 2, wobei die zweite Spannungsteilungsstufe (E2) aus elektronischen Bauteilen besteht, die austauschbare Kondensatoren und/oder Widerstände umfassen.

4. Spannungssensor für eine Gleichstromleitung mit sehr hoher Spannung nach Anspruch 3, wobei die zweite Spannungsteilungsstufe (E2) mindestens einen Kondensator und mindestens einen Widerstand in Parallelschaltung umfasst, die in einem dichten Gehäuse enthalten sind, wobei ein geschirmtes Kabel die zweite Spannungsteilungsstufe elektrisch mit der ersten Spannungsteilungsstufe verbindet.

5. Spannungssensor für eine Gleichstromleitung mit sehr hoher Spannung nach einem der vorstehenden Ansprüche, wobei eine elektronische Schaltung (C) einen Eingang aufweist, der mit einem Ausgang der zweiten Spannungsteilungsstufe verbunden ist, und die elektronische Schaltung (C) Schaltungen zur Verarbeitung des Signals umfasst, das sie an ihrem Eingang empfängt.

6. Spannungssensor für eine Gleichstromleitung mit sehr hoher Spannung nach Anspruch 5, wobei die Verarbeitungsschaltungen einen Analog/Digital-Wandler umfassen.

7. Spannungssensor für eine Gleichstromleitung mit sehr hoher Spannung nach einem der vorstehenden Ansprüche, wobei die erste Spannungsteilungsstufe mit Temperaturmessmitteln ausgestattet ist, die dazu geeignet sind, eine Temperatur des Sensors zu liefern.

8. Spannungssensor für eine Gleichstromleitung mit sehr hoher Spannung nach Anspruch 7, wenn Anspruch 7 von Anspruch 5 oder 6 abhängt, wobei die elektronische Schaltung (C) Mittel umfasst, die dazu geeignet sind, Temperaturdrifts der Widerstandswerte und/oder der Kondensatorkapazitätswerte der ersten und/oder der zweiten Spannungsteilungsstufe auf der Basis von Temperaturmessungen, die von den Temperaturmessmitteln geliefert werden, zu korrigieren.

9. Spannungssensor für eine Gleichstromleitung mit sehr hoher Spannung nach einem der vorstehenden Ansprüche, wobei die sehr hohe Spannung im Bereich zwischen 100 kV Gleichspannung und 1100 kV Gleichspannung beträgt, und die Zwischenspannung im Bereich zwischen 100 V und 200 V Gleichspannung beträgt.

10. Spannungssensor für eine Gleichstromleitung mit sehr hoher Spannung nach einem der vorstehenden Ansprüche, wobei der Verbundisolator (I) ein mit Silikonrippen (b1, b2) überzogenes Epoxid-Glasfaser-Rohr ist.

**Claims**

1. Very high voltage DC line voltage sensor, the sensor being made up of a voltage divider comprising two series-connected voltage division stages, an intermediate voltage being taken at the connection point of the two voltage division stages, a first voltage division stage (E1) being made up of at least two series-mounted elementary voltage division stages (Em) and distributed in a composite insulator (I), each elementary voltage division stage (Em) comprising at least one capacitor (Ce) and at least one resistor (Re) in parallel, **characterised in that** the capacitor and the resistor each have a first terminal fastened on a first electrically conductive plate (a1) and a second terminal, opposite the first terminal, fastened on a second electrically conductive plate (a2), the first electrically conductive plate (a1) and the second electrically conductive plate (a2) each being surrounded by a electrically conductive cover (T), at least one electrically insulating holding piece (S) that surrounds the resistor and the capacitor being in contact with the inner wall of the composite insulator (I) in order to fasten the capacitor and the resistor to the inside of the composite insulator.

2. Very high voltage DC line voltage sensor according to claim 1, wherein the first electrically conductive plate (a1) and a rigid plate in a first mechanical electrically conductive holding piece and the second electrically conductive plate (a2) is made up of a flexible metal sheet in the shape of a spider integral with a steel ring of a second mechanical electrically conductive holding piece (a1) and a second electrically conductive plate (a2) of the same mechanical electrically conductive holding piece being connected to one another by electrically conductive spacers (Ent).

3. Voltage sensor according to one of claims 1 or 2, wherein the second voltage division stage (E2) is made up of electronic components comprising capacitors and/or resistors that are interchangeable.

4. Very high voltage DC line voltage sensor according to claim 3, wherein the second voltage division stage (E2) comprises at least one capacitor and at least one resistor in parallel contained in a sealed box, a shielded cable electrically connecting the second voltage division stage to the first voltage division stage.

5. Very high voltage DC line voltage sensor according to any preceding claim, wherein an electronic circuit (C) has an input connected to an output of the second voltage division stage and the electronic circuit (C) comprises circuits for processing the signal that it receives on its input.

6. Very high voltage DC line voltage sensor according to claim 5, wherein the processing circuits include an analogue/digital converter.

7. Very high voltage DC line voltage sensor according to any preceding claim, wherein the first voltage division stage is provided with means for measuring the temperature able to deliver a temperature of the sensor.

8. Very high voltage DC line voltage sensor according to claim 7, when the claim 7 depends on claim 5 or 6, wherein the electronic circuit (C) comprises means able to correct temperature drifts of resistor values and/or of capacitor capacitance values of the first and/or of the second voltage division stage, based on the temperature measurements delivered by the means for measuring temperature.

9. Very high voltage DC line voltage sensor according to any preceding claim, wherein the very high voltage is between 100kV and 1100kV DC and the intermediate voltage is between 100V and 200V DC.

10. Very high voltage DC line voltage sensor according to any preceding claim, wherein the composite insulator (I) is a tube made of epoxy glass fibre covered with silicone fins (b1, b2).

# FIG. 1

# FIG. 2

I

a1

Ent

a2

Re2

a1

Ent

M1

T

Re1

Ce

S

T

M2

a2

# FIG. 3

θ

b2

b1

d

h

# FIG. 4

b2

H

**EP 2 920 597 B1**

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- WO 2008148727 A1
- EP 0980003 A1
- WO 9915906 A1